# EUROPEAN PATENT APPLICATION

(11) **EP 4 026 434 A1**
(43) Date of publication of application: **13.07.2022**
(21) Application number: 21151200.9
(22) Date of filing: 12.01.2021
(51) Int. Cl.: A24F 40/40, H05K 5/00, H05K 1/02, H05K 9/00

(54) **AEROSOL GENERATION DEVICE WITH CONDUCTIVE OUTER CASING CONNECTED TO PCBA**

(71) Applicant: JT International SA, 1202 Geneva (CH)
(72) Inventor: ADAIR, Kyle, Lisburn, BT28 2UW (GB); POPOOLA, Olayiwola Olamiposi, Walton-on-Thames, KT12 2SJ (GB); LOVEDAY, Peter, Woking, Surrey, GU24 9PW (GB)
(74) Representative: Bardehle Pagenberg Partnerschaft mbB Patentanwälte Rechtsanwälte

(57) **Abstract**

The present invention is directed to an aerosol generation device 1. The aerosol generating device allowing a user to consume a consumable (2), comprises: an outer casing comprising a frame 11 which comprises conductive material, and a receiving cavity (13) arranged for receiving the consumable (2), and a printed circuit board assembly 12; wherein the ground 124 of the PCBA is electrically connected to the frame 11.

## Description

### TECHNICAL FIELD

The present invention is directed to an aerosol generation device. More specifically, the present invention is directed to an aerosol generation device with a conductive outer casing connected to a printed circuit board assembly, and a printed circuit board assembly for the aerosol generation device.

### BACKGROUND

An aerosol generation device, or E-cigarette, is now a mainstream product to simulate a traditional tobacco cigarette. There are many types of aerosol generation devices, and the one which still has tobacco or volatile substrate inside is one of the most popular types. By heating but not burning the consumable, this one type of the aerosol generation device does not release the by-products of combustion such as tar and carbon monoxide. The operation method of the aerosol generation device is to contain an aerosol generation carrier inside and to heat it, but not to its burning point. There is also another type of E-cigarette, the operation method of which is to evaporate liquid to form smoke. For both types of aerosol generation devices, a compact and portable design is important.

Having a compact a portable body means that the aerosol generation devices, usually having electronic components such as battery, are vulnerable from outer force such as dropping, and electromagnetic fields in daily life. At the same time, as an electronic device the user usually holds in their hand, the battery and other electronic components may cause an electrical shock to the user and discomfort.

There have been attempts so solve the above technical problems, such as in the Chinese patent application CN110403247, in which the use of a silica gel protection sleeve is disclosed. However, this approach still has drawbacks, because it increases the size of the aerosol generation device, and it may be hard to clean the device from the silica gel protection. Having a protection sleeve which the user needs to take on and off constantly may also affect the user experience.

### SUMMARY OF THE INVENTION

The present invention provides a smoking article for an aerosol generation device, which solves some of or all of the above problems.

A 1st embodiment of the invention is directed to an aerosol generating device allowing a user to consume a consumable, comprising:
- an outer casing comprising a frame which comprises conductive material, and a receiving cavity arranged for receiving the consumable, and
- a printed circuit board assembly;
wherein the ground of the PCBA is electrically connected to the frame.

By connecting the outer casing to the ground of the printed circuit board, the conductive outer casing can be used as a ground or a "ground plane" to the earth for the electrical parts of the device. This arrangement gives the electricity the simplest path to return to the ground and avoids the user to experience electric shocks in certain instances.

According to a 2nd embodiment, in the 1st embodiment, the PCBA comprises an area of exposed copper acting as the ground of the PCBA.

According to a 3rd embodiment, in any one of the preceding embodiments, the aerosol generating device comprises an internal chassis and/or board, wherein an electrical power supply unit is mounted on the internal chassis and/or board.

With this arrangement, the electronic components and the PCB are better protected and fixed in the device.

According to a 4th embodiment, in the preceding embodiment, the PCBA is attached to the frame through an attaching means mounted on each of the internal chassis and/or board, the PCBA and the frame, to hold them together.

According to a 5th embodiment, in the preceding embodiment, the attaching means is a threaded section for a screw to pass through or a bayonet type.

With this arrangement, all the relevant parts of the aerosol generation device are firmly attached to each other and share the electric ground of the PCBA.

According to a 6th embodiment, in any one of the preceding embodiments, the frame forms an outer edge of the device.

With this arrangement, the inner parts including the PCBA are well protected.

According to a 7th embodiment, in any one of the preceding embodiments, the aerosol generating device has a substantially cuboid shape with right angle corners and/or curved corners.

According to an 8th embodiment, in any one of the preceding embodiments, the aerosol generating device has two substantially parallel main surfaces and one or more circumferential side surfaces between the two main surfaces.

According to a 9th embodiment, in the preceding embodiment, the frame forms at least part of the one or more circumferential side surfaces.

According to a 10th embodiment, in any one of the 8th or 9th embodiments, the circumferential side surfaces have a width configured to completely cover and protect at least one of the PCBAs arranged perpendicular to the main surfaces and/or parallel to the circumferential side surfaces inside the aerosol device.

With this arrangement, the PCBAs inside the aerosol generation device are protected from the side aspects.

According to an 11th embodiment, in any one of the 8th to 10th embodiments, the one or more circumferential side surfaces have curved sections that connect the two opposite main surfaces substantially on the two opposite main surfaces, so that the circumferential side surfaces of the frame are capable of protecting the main surfaces if the aerosol generating device drops or is stressed by an external distorted force.

According to a 12th embodiment, in any one of the preceding embodiments, the frame comprises one or more overhang members, ribs and/or guiding means configured to allow mechanical protection of components within the device in case of device drop or impact and/or torsion of the device.

According to a 13th embodiment, in any one of the preceding embodiments, the frame comprises at least one, preferably two corners at the base of the frame.

According to a 14th embodiment, in any one of the preceding embodiments, the frame comprises or preferably consists of metal, preferably aluminum.

With this arrangement, the device is more light weight and portable, while being rigid and capable of shielding electromagnetic fields.

A 15th embodiment of the invention is directed to a printed circuit board assembly for an aerosol generating device according to any one of the preceding claims, wherein the ground of the PCBA is electrically connected to a conductive frame of the aerosol generating device.

Preferred embodiments are now described, by way of example only, with reference to the accompanying drawings.

### BRIEF DESCRIPTION OF THE DRAWINGS

- Figure 1:: is an exploded schematic illustration view of an aerosol generation device according to an exemplary embodiment of the present invention;
- Figure 2:: shows a partial and enlarged schematic illustration of the aerosol generation device with details of the PCBA and outer casing therein according to the exemplary embodiment of the present invention.

### DETAILED DESCRIPTION OF THE PREFERRED EMBODIMENTS

Preferred embodiments of the present invention are described hereinafter and in conjunction with the accompanying drawings.

As used herein, the term "aerosol generation device" or "electronic cigarette" may include an electronic cigarette configured to deliver an aerosol to a user, including an aerosol for smoking. "Printed circuit board" or "PCB" are well-known terms for the skilled person, and refers to an element which supports and uses etched conductive tracks (trace, lines), pads and other features, to electrically connect electrical or electronic components. Herein, "PCB" may also mean Printed Circuit Board Assembly (PCBA), which means the substrate of the PCB board and the components thereon. The illustrated embodiments of the aerosol generation system and the PCB therein are schematic, and it is also possible to combine some of the parts to single units or elements, which will be apparent to a person skilled in the art. Herein, "coupled" or "connected" may mean "electrically coupled" or "electrically connected", wherein the connection may be via other components such as transistors or capacities for purposes known to the skilled person. "Printed circuit board substrate" may refer to the printed circuit board per se, namely the combination of the unconducive substrate layer and the copper layer which makes the circuit board, or the unconducive substrate layer per se, without the components mounted or soldered thereon.

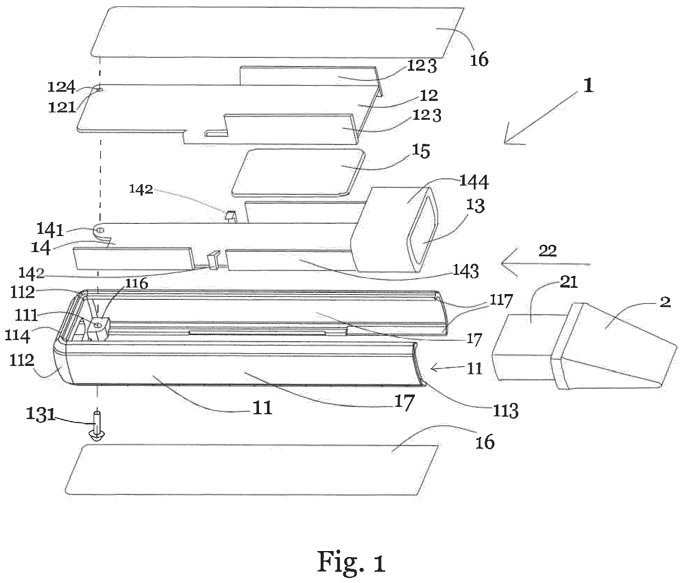

In **Fig. 1****,** an exploded schematic illustration view of an embodiment of an aerosol generation device 1 and a cartridge 2 comprising a consumable are shown in a simplified manner. The aerosol generation device 1 comprises the outer casing or housing, the printed circuit board assembly, an electrical power supply unit 15 (preferably a LiPo battery), and an internal chassis and/or board 14. The illustrated embodiments of the aerosol generation system in this invention are schematic, and it is also possible to combine some of the parts to single units, such as the aerosol inlet and outlet, operator or computer modules, which is apparent to a person skilled in the art.

The cartridge 2 comprises a mouthpiece part and a consumable container containing the consumable, which is in the form of a liquid. The liquid can be inhaled by a user from the mouthpiece part with the power support of the device 1. The liquid typically comprises an aerosol-forming substance, such as glycerin or propylene glycol that creates the vapor. Other common substances in the liquid are nicotine and various flavorings. In other embodiments, other common consumables, such as substrates having nicotine, can be used and inserted into the aerosol generation device 1 for consuming.

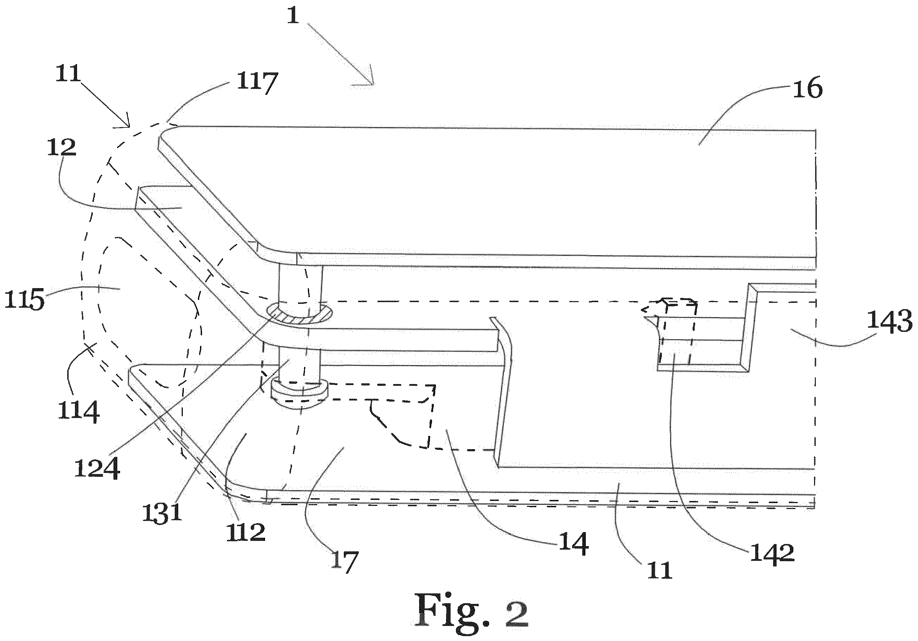

Hereinafter, the **aerosol generation device 1** is described more specifically together with reference to figures 1 and 2.

The outer casing of the aerosol generation device 1 comprises a frame 11 (shown with dashed lines in figure 2) and two substantially parallel main surfaces 16. In this present embodiment, the internal chassis 14 also forms a part of the outer casing. Specifically, a cartridge socket 144 integrated in or detachable attached to the internal chassis 14 has a cavity 13 exposed at a top end of the outer casing. The cartridge 2 can be inserted into the cavity 13 in the insertion direction 22. The cartridge 2 is at least electrically connected with the electrical contacts in the cavity 13, which provide the electric power to the one or more heater elements comprised in the cartridge 2. In other embodiments, one or more heater elements may be arranged in the cavity 13 for heating the consumable. The electric power flows from the LiPo battery 15 through the PCBA 12 to the cartridge socket 144, which are all electrically connected with each other. The LiPo battery can be charged through a USB port 115. The PCBA 12 and the LiPo battery 15 are mounted together on the inner chassis 14 and the frame 11 with a screw 131 and/or bayonet mounts 142. Specifically, the screw 131 is fixed and passing through the threaded section 111 in a base 116, which protrudes from the inside surfaces of the frame 11, the thread section 141 of the inner chassis 14 (shown with thicker dashed lines in figure 2), and the thread section 121 of the PCBA 12, preferably countersunk holes that are through holes without threading or countersinking, in the direction perpendicular to the insertion direction 22. The thread is conductive and comprises or preferably is made of metal, preferably aluminum and/or copper. The inner chassis comprises bayonet type clips or clasps 116 so as to further fix the LiPo battery 15 and the PCBA 12 to the inner chassis firmly.

Hereinafter, the **frame 11 of the device** 1 is described more specifically, with reference to figures 1 and 2.

The frame 11, which forms the outer edges of the aerosol generation device 1, comprises and preferably is made of conductive material, such as metal, preferably aluminum. The benefit of using an aluminum structure is to have both the advantage of lightweight and rigid performance. At the same time, the aluminum can substantially prevent the inner electronic components from being affected by the magnetic fields in daily life.

The frame 11 substantially has a U-shape or cuboid shape, with two right-angle corners close to the cavity 13 end, and two rounded or curved corners arranged at the base end, which is the end opposite to the cavity 13 end. The frame 11 forms three circumferential side surfaces 17 between and substantially perpendicular to the two main surfaces. One of the circumferential surfaces is the base end. Except for the curved comers, the frame 11 has curved sections at the connection parts or the seams 117 of the main surface and the frame, wrapping around or covering the edges of the main surfaces, which form overhang members on the edges of the frame 11. The highest point or surface of the connection parts or the seams 117 or the overhang members, seen from a perspective parallel to the main surfaces, preferably protrudes higher than the main surfaces 16, so as to protect the main surfaces, which are attached to or under the overhang members. Hence, besides the cavity end, all the edges and/or corners of the frame are curved. The main frame is attached to the frame through guiding means, such as slots, and ribs may be formed inside the frame 11 so as to enhance the rigidity of the frame 11. The main surfaces 16 are preferably slidingly attached to the frame 11 through the slots. With this arrangement, the main surfaces 16 and the frame 11 can be detached from each other repeatedly for cleaning after use.

With the above frame structure, the frame 11 protects the aerosol generating device 1 from dropping and external distorted forces. Further, the shielding by the frame 11 of the device 1 can reduce the coupling of radio waves, electromagnetic fields, and electrostatic fields, this is known as RF shielding, and the aluminum frame 11 can be referred to as a faraday cage since it reduces the RF exposure.

Hereinafter, the **PCBA 12 of the device 1** is described more specifically, with reference to figures 1 and 2.

The PCBA 12 is arranged parallel to the main surfaces. In the present embodiment, preferably, two other sub-printed circuit boards 123 are arranged substantially perpendicular to and aside from the main PCBA 12. In some embodiments, at least some parts of the main PCBA 12 and/or the sub-PCBA 123 boards are flexible PCBs, which form the connection between the main PCBA and the sub PCBA board. More specifically, the sub-PCBA boards are flexible PCBs, and have a part which is bent or curved and is connected to the main PCBA board, preferably being in part sandwiched between two layers of the main PCBA board, and form at least one layer of the main PCBA board. In another embodiment, the main PCBA 12 and the sub-PCBAs 123 are one flexible PCBA board, which is bent or curved between the main and the sub-PCBA boards 12, 123. In other embodiments, electrical lines or cables connecting the main PCBA and sub PCBAs are bent or curved. The main PCBA and the sub-PCBA share one electrical or signal ground. In other words, the electrical ground of the main PCBA and the sub-PCBA are connected.

Since a part of the sub-PCBA 123 is substantially perpendicular to the main PCBA 11 and substantially parallel to the circumferential side surfaces, namely the frame 11, the frame 11 or the circumferential side surfaces 17 are preferably arranged in the way that the width of the frame 11, which is a dimension in a direction perpendicular to the insertion direction, completely covers and protects the sub-PCBAs 123.

In the present invention, the threaded section 121 has an area of exposed copper acting as and connecting the ground 124 (shown with slashes in figure 2) of the PCBAs. The screw, which comprises and preferably is made of metal, is directly connected to the copper area, namely the electrical ground, preferably with solder. In some embodiments, the inner chassis 14 is also made of or comprises conductive material, such as metal, preferably aluminum. Alternatively, the inner chassis 14 is nonconductive. Since the attaching means hold the PCBAs 12, 123, more specifically the ground of the PCBA, and the frame together, the ground of the PCBA 12, 123 is electrically connected to the conductive aluminum frame 11.

With this arrangement, the aluminum frame 11 of the aerosol generation device 1 is used as a ground or "ground plane" to the earth. Hence, the electrical parts of the aerosol generation device 1 can use the frame as a ground to attach to. This gives the electricity the simplest path to return to the ground. Without this, the user could experience an electric shock in certain instances.

## Claims

1. Aerosol generating device (1) allowing a user to consume a consumable, comprising:
- an outer casing comprising a frame (11) which comprises conductive material, and a receiving cavity (13) arranged for receiving the consumable (2), and
- a printed circuit board assembly (12);
wherein the ground (124) of the PCBA (12) is electrically connected to the frame (11).

2. Aerosol generating device (1) according to claim 1, wherein the PCBA (12) comprises an area of exposed copper acting as the ground (124) of the PCBA.

3. Aerosol generating device (1) according to any one of claims 1 or 2, comprising an internal chassis and/or board (14), wherein an electrical power supply unit (15) is mounted on the internal chassis and/or board (14).

4. Aerosol generating device (1) according to the preceding claim, wherein the PCBA (12) is attached to the frame (11) through an attaching means (15) mounted on each of the internal chassis and/or board (14), the PCBA (12) and the frame (11), to hold them together.

5. Aerosol generating device (1) according to the preceding claim, wherein the attaching means (131) is a threaded section for a screw to pass through or a bayonet type.

6. Aerosol generating device (1) according to any one of preceding claims, wherein the frame (11) forms an outer edge of the device (1).

7. Aerosol generating device (1) according to any one of preceding claims, wherein the aerosol generating device (1) has a substantially cuboid shape with right angle corners and/or curved corners.

8. Aerosol generating device (1) according to any one of preceding claims, wherein the aerosol generating device (1) has two substantially parallel main surfaces (16) and one or more circumferential side surfaces (17) between the two main surfaces (16).

9. Aerosol generating device (1) according to the preceding claim, wherein the frame (11) forms at least part of the one or more circumferential side surfaces (17).

10. Aerosol generating device according to claims 8 or 9, wherein the circumferential side surfaces (17) have a width configured to completely cover and protect at least one of the PCBAs (123) arranged substantially perpendicular to the main surfaces and/or parallel to the circumferential side surfaces (17) inside the aerosol device (1).

11. Aerosol generating device according to any one of the preceding claims 8 to 10, wherein the one or more circumferential side (17) surfaces have curved sections that connect the two opposite main surfaces (16) substantially on the two opposite main surfaces, so that the circumferential side surfaces (17) of the frame (11) are capable of protecting the main surfaces (16) if the aerosol generating device drops or is stressed by an external distorted force.

12. Aerosol generating device according to any one of preceding claims, wherein the frame (11) comprises one or more overhang members, ribs and/or guiding means configured to allow mechanical protection of components within the device in case of device drop or impact and/or torsion of the device.

13. Aerosol generating device according to any one of preceding claims, wherein the frame comprises at least one, preferably two corners at the base of the frame.

14. Aerosol generating device according to any one of preceding claims, wherein the frame comprises or preferably consists of metal, preferably aluminum.

15. Printed circuit board assembly for an aerosol generating device according to any one of the preceding claims, wherein the ground (124) of the PCBA (12) is configured to be electrically connected to a conductive frame of the aerosol generating device.
